# EUROPÄISCHE PATENTSCHRIFT

(11) **EP 0 833 164 B1**
(45) Veröffentlichungstag und Bekanntmachung des Hinweises auf die Patenterteilung: **22.12.2004**
(21) Anmeldenummer: 97113598.3
(22) Anmeldetag: 06.08.1997
(51) Int. Cl.: G01R 31/01

(54) **Kontakteinrichtung zum Testen von elektrischen Bauelementen in Bestückautomaten**
Contact device for testing electrical components in mounting machines
Dispositif de contact pour tester des composants électriques dans un automate de montage

(30) Priorität: 27.09.1996 DE 19640007
(43) Veröffentlichungstag der Anmeldung: 01.04.1998
(73) Patentinhaber: SIEMENS AKTIENGESELLSCHAFT, 80333 München (DE)
(72) Erfinder: Wacker, Josef, 82335 Berg (DE)

(56) Entgegenhaltungen:
- EP-A- 0 306 653
- EP-A- 0 315 799
- WO-A-96/16338
- US-A- 4 763 405

## Beschreibung

Die Erfindung bezieht sich auf eine Kontakteinrichtung zum Testen elektrischer Werte von unterschiedlichen elektrischen Bauelementen, die an einem Sauggreifer eines Bestückkopfes für die Bauelemente gehalten sind.

Durch die Firmenschrift Siemens SMD-Speed-Placer SP120 für hohe Bestückleistung und große Bauelemente-Vielfalt, Nr. 190305 SB 78910, Seite 4 ist ein verfahrbarer Revolverkopf zur Aufnahme von elektrischen Bauelementen bekannt geworden, bei dem die Bauelemente an Sauggreifern eines Revolverrades gehalten sind und schrittweise zu verschiedenen am Umfang des Revolverkopfes fest angeordneten Stationen transportiert werden können. Eine Zentrier- und Teststation ist mit gegeneinander beweglichen Fingern versehen, die das Bauelement zentrieren und kontaktieren. Dabei erfordern unterschiedlich breite bzw. lange Bauelemente einen großen Bewegungsbereich der Finger mit entsprechend hoher Zustellgeschwindigkeit. Eine derartige Anordnung erfordert wegen der verschiedenen Bewegungsrichtungen und der großen Wegstrecken einen erheblichen Zeitaufwand und mechanischen Aufwand, der ein entsprechend hohes Gewicht der Station bedingt.

Ferner ist durch die WO 96/16338 ein Testeinrichtung für einen an einem Greifer gehaltenen IC bekannt geworden, bei der die schmalen Anschlußelemente durch den Greifer auf entsprechend angepaßte Leiterbahnen einer Leiterplatte aufgesetzt werden. Die Leiterplatte ist in diesem Bereich so dünn gehalten, daß ihr Kontaktierbereich federnd nachgiebig ausgebildet ist. Die genaue Übereinstimmung der Leiterbahnen mit den Anschlußelementen erfordert für unterschiedliche Bauelemente mit unterschiedlich konfigurierten Anschlußelementen entsprechend unterschiedliche Testeinrichtungen.

US 4 763 405 A beschreibt eine Kontaktier einrichtung zum Testen elektrischer Werte um elektrischen Bauelementen gemäß den Merkmalen des oberbegriffs des Anspruchs 1.

Der Erfindung liegt die Aufgabe zugrunde, eine einfache Kontakteinrichtung zu schaffen, die sich zum Kontaktieren von unterschiedlichen Bauelementen eignet. Diese Aufgabe wird durch die Erfindung gemäß Anspruch 1 gelöst.

Die in einer Ebene großflächig angeordneten Kontaktflächen überdecken einen großen Kontaktierbereich für unterschiedlich große Bauelemente. Durch die federnde Abstützung der Kontaktstücke können sich diese Höhenunterschieden der Anschlußelemente des Bauelementes anpassen. Da die Dicke der Bauelemente nur geringe Unterschiede aufweist, wird nur eine kleine Hubbewegung benötigt, um die Anschlußelemente zu kontaktieren. Eine derartige kurze Bewegung erfordert nur einen einfachen Antrieb mit einem linearen oder schwenkbaren Vorschub. Die Kontaktstücke können z.B. auf Isolierstoffkörper aufgebracht sein, die auf Blattfedern befestigt sind.

Durch die Bewegbarkeit des Kontaktträgers ist es möglich, die Kontaktiereinrichtung an einem stationären Teil des Bestückkopfes anzubringen, ohne daß der Greifer eine Hubbewegung ausführen muß, die z.B. an einem verfahrbaren Revolver- Bestückkopf mit einer Vielzahl von verdrehbaren Vakuumspindeln nur mit erheblichem Vorrichtungsaufwand zu erzielen wäre.

Bei modernen Anlagen ist es üblich, die Lage der Bauelemente optisch zu erfassen und die Lageabweichung beim Aufsetzen der Bauelemente auf die Leiterplatte zu berücksichtigen. Eine genaue mechanische Zentrierung ist daher nicht mehr erforderlich. Die elektrische Prüfung erfolgt lediglich zu dem Zweck, die verschiedenen Bauelemente voneinander zu unterscheiden, um Verwechslungen zu vermeiden. An die Kontaktqualität werden daher keine hohen Ansprüche gestellt.

Die erfindungsgemäße Vorrichtung eignet sich daher für diesen Zweck in vollem Umfang. Die Station verringert das Gewicht des verfahrbaren Revolverkopfes mit entsprechender Verringerung der auftretenden Massenkräfte.

Vorteilhafte Weiterbildungen der Erfindung sind in den Ansprüchen 2 bis 5 gekennzeichnet.

Durch die Weiterbildung nach Anspruch 2 wird die Hubeinrichtung der Kontaktiereinrichtung zugeordnet, wodurch das verdrehbare Revolverrad entsprechend leicht bleibt.

Durch die Weiterbildung nach Anspruch 3 können die Anschlußelemente mit den Kontaktflächen mehrfach kontaktiert werden, wodurch sich die Kontaktsicherheit erhöht. Außerdem ist es möglich, Bauelemente mit höherer Kontaktzahl zu kontaktieren. Vorzugsweise sind 4 Kontaktstücke von quadratischem Umriß auf dem quadratischen Kontaktträger angebracht. Die Bauelemente können dann je nach Abhollage in beiden Koordinatenrichtungen orientiert kontaktiert werden, ohne zuvor verdreht werden zu müssen.

Durch die Weiterbildung nach Anspruch 4 können die Kontaktstücke in einfacher Weise auf dem Kontaktträger angeordnet und befestigt werden.

Die schräge z.B. dachförmige Neigung der Kontaktflächen nach Anspruch 5 ermöglicht einen Kantenkontakt zum Bauelement mit verbesserter Kontaktsicherheit.

Im folgenden wird die Erfindung anhand von in der Zeichnung dargestellten Ausführungsbeispielen näher erläutert.
- Figur 1: zeigt schematisiert einen Schnitt durch eine Kontakteinrichtung mit einem an einem Sauggreifer gehaltenen elektrischen Bauelement,
- Figur 2: eine Draufsicht auf die Kontakteinrichtung nach Figur 1,
- Figur 3: die Kontakteinrichtung nach Figur 1 mit einer geänderten Kontaktoberfläche,
- Figur 4: eine Draufsicht auf die Kontakteinrichtung nach Figur 3,
- Figur 5: die Kontakteinrichtung nach Figur 4 mit um 45° gedrehten Kontaktflächen.

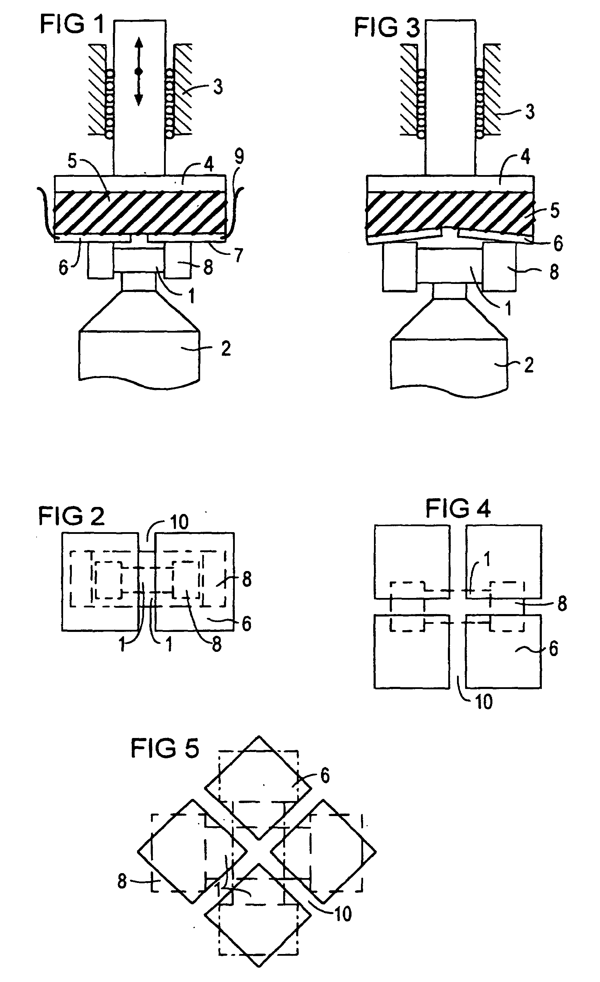

Nach den Figuren 1 und 2 ist ein elektrisches Bauelement 1 an einem Sauggreifer 2 eines nicht näher dargestellten Revolver-Bestückkopfes eines Bestückautomaten gehalten. Das Bauelement 1 befindet sich unter einer Kontakteinrichtung 3, die an einem stationären Teil des Revolverkopfes gehalten ist. Die Kontakteinrichtung 3 ist mit einem Halter 4 für einen Kontaktträger 5 versehen, der auf das Bauelement 1 zu verschiebbar gelagert ist.

Der elastomere Kontaktträger 5 trägt auf der dem Halter 4 abgewandten Seite Kontaktstücke 6, die auf der dem Bauelement 1 zugewandten Seite in einer Ebene liegende Kontaktflächen 7 aufweisen. Diese sind auf kappenartige Anschlug elemente 8 des Bauelementes 1 aufgesetzt und mit diesen kontaktiert. An die Kontaktstücke 6 sind elektrische Leitungen 9 angeschlossen, die zu einer elektronischen Testeinrichtung führen. Eine schmale Trennfuge 10 zwischen den Kontaktstücken 6 ermöglicht eine hinreichende Isolation bei möglichst großen Kontaktflächen, die sich sowohl für kurze wie auch lange Bauelemente eignen.

In Figur 2 sind zwei unterschiedlich große Bauelemente einander überdeckend dargestellt, es ist erkennbar, daß deren Anschlußelemente in beiden Fällen innerhalb der beiden Kontaktstücke 7 liegen.

Nach den Figuren 3 und 4 ist der Kontaktträger 5 mit vier quadratischen Kontaktstücken 6 versehen, mit denen eine Doppelkontaktierung der Anschlußelemente 8 des Bauelementes 1 möglich ist. Die Kontaktstücke 4 eignen sich aber auch dafür, z.B. Bauelemente mit vier Anschlußelementen zu kontaktieren. Die Kontaktflächen 7 liegen hier nicht in einer Ebene sondern auf einer Mantelfläche eines Hohlkegels. Sie sind daher zur Bauelementeebene geringfügig geneigt. Dadurch kommt es zu einem Kantenkontakt zwischen den Anschlußelementen 8 und den Kontaktstücken 6, wodurch sich die Kontaktsicherheit erhöht.

Nach Figur 5 sind die Kontaktstücke 6 nach Figur 4 um 45° verdreht, so daß sich das Bauelemente 1 diagonal erstreckt. Diese Anordnung erhöht die Kontaktbreite, wodurch noch längere Bauelemente kontaktiert werden können. Das Bauelement 1 kann in gleicher Weise kontaktiert werden, wenn es entsprechend seiner Abhollage um 90° gedreht angeordnet ist, wie dies durch die strichpunktierten Linien angedeutet ist.

### Bezugszeichen

- 1: Bauelement
- 2: Sauggreifer
- 3: Kontakteinrichtung
- 4: Halter
- 5: Kontaktträger
- 6: Kontaktstück
- 7: Kontaktfläche
- 8: Kontaktelement
- 9: Leitung
- 10: Trennfuge

## Patentansprüche

1. Kontaktiereinrichtung (3) zum Testen elektrischer Werte von elektrischen Bauelementen (1) mit Anschlußelementen von unterschiedlicher Konfiguration und Größe,
wobei die Bauelemente an einem Sauggreifer (2) eines Bestückkopfes für die Bauelemente (1) gehalten sind,
wobei die Kontaktiereinrichtung (3) im Bewegungsbereich des Sauggreifers (2) angeordnet ist und wobei Prüfkontakte der Kontaktiereinrichtung (3) mit Anschlußelementen (8) des Bauelementes (1) kontaktierbar sind,
wobei die Prüfkontakte als Kontaktstücke (6) ausgebildet sind, deren Kontaktflächen (7) großflächig parallel zu den Anschlußelementen (8) des getesteten Bauelementes (1) angeordnet sind,
**dadurch gekennzeichnet, daß** sämtliche Kontaktstücke (6) mit den in eine Richtung weisenden Kontaktflächen (7) auf einer dem Bauelement zugewandten Seite eines gemeinsamen, im wesentlichen senkrecht zu den Kontaktflächen (7), federnden Kontaktträgers gehalten sind,
daß die Kontaktstücke (6) mittels ihrer Kontaktflächen (7) mit den eine gemeinsame Ebene bildenden Anschlußelementen (8) des Bauelements (1) durch eine Hubbewegung des Kontaktträgers relativ zum Sauggreifer kontaktierbar sind und daß die Kontaktstücke durch schmale Trennfugen (10) elektrisch gegeneinander isoliert sind.

2. Kontakteinrichtung nach Anspruch 1,
**dadurch gekennzeichnet, daß** der Kontaktträger (5) an einem senkrecht zu den Kontaktflächen (7) verschiebbaren, angetriebenen Halter (4) befestigt ist.

3. Kontakteinrichtung nach Anspruch 1 oder 2,
**dadurch gekennzeichnet, daß** mehr als zwei flache Kontaktstücke (6) auf dem Kontaktträger (5) angeordnet sind.

4. Kontakteinrichtung nach Anspruch 1, 2 oder 3,
**dadurch gekennzeichnet,**
**daß** der Kontaktträger (5) aus elastomerem Material besteht und
**daß** die flachen Kontaktstücke (6) daran angeklebt sind.

5. Kontakteinrichtung nach einem der Ansprüche 1 bis 4,
**dadurch gekennzeichnet,**
**daß** die Kontaktflächen (7) der Kontaktstücke (6) anstatt parallel schräg zur Kontaktierebene der Bauelemente geneigt angeordnet sind

## Claims

1. Contact device (3) for testing electrical values of electrical components (1) with connecting elements of different configuration and size,
where the components are held on a suction gripper (2) of a mounting head for the components (1),
where the contact device (3) is arranged in the area of movement of the vacuum gripper (2) and where test contacts of the contact device (3) can be contacted with connecting elements (8) of the component (1)
where the test contacts are embodied as contact pieces (6) with a large area of their contact surfaces (7) being arranged in parallel to the connecting elements (8) of the tested component (1),
that all contact pieces (6) with contact surfaces (7) pointing in one direction are held on a side facing the component of a sprung contact carrier essentially perpendicular to the contact surfaces (7),
that the contact pieces (6) can be contacted, by means of their contact surfaces (7), with the connecting elements (8) of the component (1) forming a common level by a lifting movement of the contact carrier relative to the vacuum gripper and that the contact pieces are electrically isolated from each other by narrow separating gaps (10).

2. Contact device according to Claim 1
**characterized in that** the contact carrier (5) is attached to a holder (4) driven so that it can be moved perpendicularly to the contact surfaces (7).

3. Contact device according to Claim 1 or 2
**characterized in that** more than two flat contact pieces (6) are arranged on the contact carrier (5).

4. Contact device according to Claim 1, 2 or 3
**characterized in that**,
the contact carrier (5) consists of an elastomer material and
that the flat contact pieces (6) are glued to it.

5. Contact device according to one of the Claims 1 to 4
**characterized in that**,
the contact surfaces (7) of the contact pieces (6), instead of being arranged in parallel, are arranged inclined at an angle to the contacting plane of the components

## Revendications

1. Dispositif de contact (3) pour tester des valeurs électriques de composants électriques (1) munis d'éléments de connexion de configuration et de taille différentes,
les composants étant tenus sur un preneur aspirant (2) d'une tête de montage pour lesdits composants (1),
le dispositif de contact (3) étant agencé dans la zone de mouvement du preneur aspirant (2) et des contacts de test du dispositif de contact (3) pouvant être mis en contact avec des éléments de connexion (8) du composant (1),
les contacts de test étant constitués par des pièces de contact (6) dont les surfaces de contact (7) sont placées, à grande surface, parallèlement aux éléments de connexion (8) du composant (1) testé,
**caractérisé en ce que** l'ensemble des pièces de contact (6) avec les surfaces de contact (7) montrant dans une direction sont tenues sur un côté orienté vers le composant d'un porte-contacts commun, élastique essentiellement perpendiculairement aux surfaces de contact (7),
**en ce que** les pièces de contact (6), au moyen de leurs surfaces de contact (7), peuvent être mises en contact avec les éléments de connexion (8) du composant (1), formant un plan commun, grâce à un mouvement de course du porte-contacts par rapport au preneur aspirant, et **en ce que** les pièces de contact sont isolées électriquement les unes des autres par des fentes de séparation (10) étroites.

2. Dispositif de contact selon la revendication 1,
**caractérisé en ce que** le porte-contacts (5) est fixé sur un support commandé (4) déplaçable perpendiculairement aux surfaces de contact (7).

3. Dispositif de contact selon la revendication 1 ou 2,
**caractérisé en ce que** plus de deux pièces de contact plates (6) sont agencées sur le porte-contacts (5).

4. Dispositif de contact selon la revendication 1, 2 ou 3,
**caractérisé en ce que** le porte-contacts (5) est en matière élastomère et
**en ce que** les pièces de contact plates (6) y sont fixées par collage.

5. Dispositif de contact selon l'une des revendications 1 à 4,
**caractérisé en ce que** les surfaces de contact (7) des pièces de contact (6), au lieu d'être placées parallèlement au plan de contact des composants, sont inclinées obliquement par rapport à celui-ci.
